# EUROPÄISCHE PATENTSCHRIFT

(11) **EP 1 567 979 B1**
(45) Veröffentlichungstag und Bekanntmachung des Hinweises auf die Patenterteilung: **11.03.2009**
(21) Anmeldenummer: 03780100.8
(22) Anmeldetag: 02.12.2003
(51) Int. Cl.: G06K 19/077

(54) **CHIPKARTE UND VERFAHREN ZUR HERSTELLUNG EINER CHIPKARTE**
CHIPCARD AND METHOD FOR PRODUCTION OF A CHIPCARD
CARTE A PUCE ET PROCEDE DE PRODUCTION D'UNE CARTE A PUCE

(30) Priorität: 05.12.2002 DE 10257111
(43) Veröffentlichungstag der Anmeldung: 31.08.2005
(73) Patentinhaber: Mühlbauer AG, 93426 Roding (DE)
(72) Erfinder: RIED, Michael, 92554 Kulz (DE); BRUNNER, Anton, 93444 Kötzting (DE)
(74) Vertreter: Hannke, Christian
(86) Internationale Anmeldenummer: PCT/EP2003/013552
(87) Internationale Veröffentlichungsnummer: WO 2004/051559

(56) Entgegenhaltungen:
- US-A- 5 519 201
- US-B1- 6 301 119

## Beschreibung

Die Erfindung betrifft eine Chipkarte sowie ein Verfahren zur Herstellung einer derartigen Chipkarte mit einem Kartenkörper und mindestens einer darin angeordneten Ausnehmung zur Aufnahme mindestens eines Chipmoduls mit Modulanschlüssen im Randbereich des Chipmoduls und einem in dem Kartenkörper eingebetteten leitfähigen Strukturkörper mit Körperkontaktanschlüssen, insbesondere einer Antenne mit Antennenanschlüssen, die unterhalb des Randbereichs des Chipmoduls angeordnet sind, gemäß den Oberbegriffen der Patentansprüche 1 und 3.

Derartige Chipkarten sind in der Regel als Kreditkarten, Bankkarten, elektronische Börsen usw. ausgebildet und dienen zur bargeldlosen Abwicklung von Transaktionen, wie beispielsweise zum Entrichten eines Beförderungsentgelts im Personennahverkehr oder zum Bezahlen eines Kaufpreises für eine Ware oder Dienstleistung. Weiterhin kann eine derartige Chipkarte auch als Ausweis für eine berührungslose Zugangskontrolle eingesetzt werden.

Üblicherweise weisen Chipkarten eine Ausnehmung zur Aufnahme eines Chipmoduls auf, welches einen integrierten Schaltkreis zur Speicherung, Verarbeitung und/oder Erkennung von Informationen, die mit einer Vorrichtung ausgetauscht werden, beinhaltet, wobei Chipkarte entweder in die Vorrichtung eingeführt oder dieser nahe gebracht wird.

Zudem beinhalten kontaktlose Chipkarten für eine Energie- und Datenübertragung mit relativ niedrigen Frequenzen Antennen, die in der Regel in den Kartenkörper einlaminiert sind und deren Antennenanschlüsse mit Modulanschlüssen des eingesetzten Chipmoduls elektrisch verbunden sein müssen.

Aus der US 5,519,201 ist ein Verfahren zur Herstellung einer Chipkarte bekannt, das Verfahren beginnt mit der Bereitstellung einer ersten flexiblen Schicht, danach wird in einem nächsten Schritt eine erste elektrisch leitende Spur über einer ersten Oberfläche der ersten flexiblen Schicht gebildet, wobei die erste elektrische Spur einen ersten elektrischen Kontakt aufweist, in einem weiteren Schritt wird eine erste elektrische oder elektromagnetische Einrichtung über der ersten Oberfläche der ersten Schicht angebracht, hierbei wird die erste Einrichtung mit der ersten Spur verbunden, in einem weiteren Schritt wird eine zweite flexible Schicht bereitgestellt, im Anschluss werden in weiteren Schritten eine Öffnung durch die zweite flexible Schicht geformt, eine Aushöhlung in der zweiten flexiblen Schicht geformt, ein flexibler, komprimierbarer, elektrisch leitender Plug in der Öffnung angeordnet, weiter wird eine dritte Schicht bereitgestellt, im Anschluss daran wird eine zweite elektrisch leitende Spur über eine zweite Oberflache der dritten Schicht angeordnet, wobei die zweite Spur einen zweiten elektrischen Kontakt aufweist, in einem nächsten Schritt findet die Anbringung einer zweiten elektronischen oder elektromagnetischen Einrichtung über der zweiten Oberfläche der dritten Schicht statt, wobei die zweite Einrichtung mit der zweiten Spur verbunden ist, im letzten Schritt wird die dritte Schicht an der zweiten Schicht, in einer Weise angebracht, dass die Öffnung an der zweiten elektrischen Verbindung ausgerichtet ist, die zweite Einrichtung ist in der Aushöhlung angeordnet und der Plug wird zwischen dem ersten und zweiten elektrischen Kontakt gestaucht.

US 6,301,119 B1 zeigt eine intrigierte Speicherkarte mit zwei Verbindungsmodi, beinhaltend einen Kontaktmodus für Kontaktflächen die an die äußere Oberfläche der Karte anliegen und einen kontaktlosen Modus in dem ein kontaktloses Verbindungselement verwendet wird. Die integrierte Speicherkarte umfasst einen Kartenkörper in den eine Verbindungsschaltung zum Verbinden eines berührungsfreien Verbindungselements mit einem Modul eingelassen ist, dass eine integrierte Schaltung umfasst die mit leitenden Bereichen verbunden ist, welche von einem Trägerfilm getragen werden. Die Verbindungsschaltung reicht in Register mit leitenden Bereichen, die dazu bestimmt sind berührungsfreie Verbindungen herzustellen und mit den leitenden Bereichen durch leitendes Material verbunden sind, welches Sacklöcher soweit auffüllt, dass sich vom Boden der besagten Löcher hin zu einer Öffnung ein Bereich erstreckt der zumindest teilweise aufgefüllt ist.

Herkömmlicherweise gibt es zwei häufig verwendete Verfahren für die Herstellung leitender Kontakte zwischen Modulanschlüssen und darunter liegenden Antennenanschlüssen bei Herstellungsverfahren von Dual Interface Karten. Bei dem so genannten ACF-Verfahren wir eine elektrische Verbindung zwischen modulunterseitig angeordneten Kontaktanschlüssen und darunter angeordneten seitlich vorstehenden Antennenanschlüssen ein Heiß- oder Schmelzkleber mit darin angeordneten leitfähigen Partikeln angeordnet, in denen der Klebstoff auf eine Oberfläche des Kartenkörpers im Bereich der Ausnehmung, in welche das Chipmodul eingesetzt wird, aufgetragen wird. Die leitfähigen Partikel erzeugen nach dem Einbau des Chipmoduls einen elektrischen Kontakt zwischen den Modulanschlüssen und den darunter liegenden Antennenanschlüssen. Hierfür wird der Heiß- oder Schmelzkleber nach seinem Auftragen und nach dem Einbau des Chipmoduls unter Berücksichtigung bestimmter Werte für die Parameter Temperatur, Druck und Zeitdauer erwärmt und ausgehärtet. Ein derartiges Verfahren wird beispielsweise in der DE 197 09 985 A1 gezeigt.

Derartige ausgehärtete Heiß- und Schmelzklebern, die zugleich eine mechanische Verbindung zwischen Chipmodul und Kartenkörper erzeugen, haben bei einer häufigen Biegebeanspruchung ein Lösen der elektrischen Verbindungen aufgrund der plastischen und elastischen Verformungseigenschaften der Heiß- und Schmelzkleber zur Folge. Hierdurch entsteht eine elektronisch unzuverlässige Verbindung in der Chipkarte, die beispielsweise vom Typ Dual-Interface ist.

Aus DE 197 47 388 C1 ist ein weiteres Verfahren zur elektrischen Verbindung von Antennen- und Chipmodulanschlüssen mittels eines leitfähigen, flüssigen Klebstoffes bekannt. In einer für die Aufnahme des Chipmoduls vorgesehen Ausnehmung (Kavität) innerhalb des Kartenkörpers wird von einer für das Aufkleben des Chipmoduls vorgesehene randseitige Klebefläche mindestens eine Bohrung zu den darunter liegenden Antennenanschlüssen gefertigt, um in diese einen leitfähigen flüssigen Klebstoff dosiert einzuführen. Nach einer derartigen Dosierung wird unmittelbar darauf das Chipmodul mit einem auf die Klebefläche aufgetragenen Klebstoff eingesetzt. Der Klebstoff wird bei einer vorbestimmten Temperatur durch Wärmeinwirkung oder bei Verwendung von zweikomponentigen Klebstoffen durch exotherme Reaktionen ausgehärtet. Aufgrund seiner steifen und harten Eigenschaften sowie unterschiedlicher Haftungseigenschaften bezüglich der zu verbindenden Teile weisen derartige Klebstoffe bei häufig auftretenden dynamischen Belastungen, wie Sie durch falsches Einschieben der Chipkarte in einen Geldautomaten oder durch Aufbewahren der Chipkarten in an sich flexibel gestalteten Portemonnaies auftreten können, häufig Kohäsions- und/oder Adhäsionsbrüche im Klebstoff durch Überdehnungs- und Ermüdungserscheinungen auf.

Demzufolge liegt der vorliegenden Erfindung die Aufgabe zugrunde, eine Chipkarte mit einem eingesetzten Chipmodul und einem in der Chipkarte integrierten leitfähigen Strukturkörper, wie eine Antenne, zu Verfügung zu stellen, die eine elektrisch dauerhafte Verbindung zwischen Chipmodul- und Körperkontaktanschlüssen selbst bei hoher und häufiger Biegebeanspruchung sicherstellt sowie ein Verfahren zur Herstellung einer derartigen Chipkarte zur Verfügung zu steilen.

Diese Aufgabe wird durch ein Herstellungsverfahren mit Merkmalen gemäß Patentanspruch 1 gelöst und die Chipkarte wird mit den Merkmalen gemäß Patentanspruch 3 hergestellt.

Ein wesentlicher Punkt der Erfindung liegt darin, dass bei einem Verfahren zur Herstellung von Chipkarten mit einem Kartenkörper , mindestens einer darin angeordneten Ausnehmung zur Aufnahme mindestens eines Chipmoduls mit Modulanschlüssen im Randbereich des Chipmoduls und einem in den Kartenkörper eingebetteten leitfähigen Strukturkörper mit Körperkontaktanschlüssen, insbesondere einer Antenne mit Antennenanschlüssen, die unterhalb des Randbereichs des Chipmoduls angeordnet sind, wobei vor dem Einbau des Chipmoduls Klebstoffteile aus elastischem, leitfähigem Material auf die Körperkontaktanschlüsse und/oder die Modulanschlüsse innerhalb von Aussparungen des Kartenkörpers derart punktweise aufgetragen und ausgehärtet lassen werden, dass sie im ausgehärteten Zustand vor der Druckbeaufschlagung die Aussparungen in Chipkartenlängs- und Chipkartenbreitenrichtung nicht ausfüllen und anschließend das Chipmodul unter Druckbeaufschlagung der Klebstoffteile aus elastischem Materials in den Kartenkörper derart eingebaut wird, dass die Klebstoffteile die nahezu gesamten Aussparungen vollständig ausfüllen.

Bei der Chipkarte sind mit dem Kartenkörper, mindestens die darin angeordneten Ausnehmung zur Aufnahme mindestens des Chipmoduls mit Modulanschlüssen im Randbereich des Chipmoduls und dem in den Kartenkörper eingebetteten leitfähigen Strukturkörper, wie einer Antenne mit Antennenanschlüssen, die unterhalb des Randbereichs des Chipmoduls angeordnet sind, dem eingebautem Chipmodul zwischen den Modulanschlüssen einerseits und den Körperkontaktanschlüssen anderseits Klebstoffteile aus elastischem leitfähigem Material unter Druckbeaufschlagung zur Kontaktherstellung zwischen den Anschlüssen angeordnet.

Derartige Klebstoffteile sind vorzugsweise punktweise auf den Körperkontaktanschlüssen oder den Modulanschlüssen vor dem Einbau des Chipmoduls aufgetragen und ausgehärtet. Anschließend wird das Chipmodul in den Kartenkörper eingebaut, wodurch die Klebstoffteile als federwirkende Puffer zwischen den Anschlüssen zusammengedrückt werden und aufgrund ihrer elastischen Eigenschaften einen dauerhaften, flexiblen, elektrischen Kontakt zwischen den Modul- und Körperkontaktanschlüssen herstellen.

Durch die Verwendung eines vorzugsweise zu Anfang flüssigen und später vor Einbau des Chipmoduls verfestigten hochgefüllten Klebstoffes auf Silikonbasis wird nach Einbau des Chipmoduls ein elektrisch leitfähiger Bump erhalten, der selbst bei hoher und häufiger Biegebeanspruchung der Chipkarte weder Risse aufweist noch einen Zwischenraum zwischen den Klebstoffsteilen und den Modul- oder Körperkontaktanschlüssen entstehen lässt.

Die Höhenabmessungen der Aussparungen in Richtung des Kartenkörperdickenverlaufs sind geringer als die Höhe der aufgetragenen Klebstoffteile ohne Druckbeaufschlagung, also vor dem Einbau des Chipmoduls. Vorzugsweise sind die aufgetragenen Klebstoffteile 0,05 - 0,15 mm höher als obere Randbereiche der Aussparungen, in welchen die Klebstoffteile angeordnet sind.

Vorzugsweise wird eine Chipkarte nach dem zuvor genannten Verfahren hergestellt.

Vorteilhaft werden bei einem Verfahren zur Herstellung von Chipkarten, Chipkarten mit einem Kartenkörper erhalten, mit mindestens einer darin angeordneten Ausnehmung zur Aufnahme mindestens eines Chipmoduls mit Modulanschlüssen im Randbereich des Chipmoduls und einem in den Kartenkörper eingebetteten leitfähigen Strukturkörper mit Körperkontaktanschlüssen, insbesondere einer Antenne mit Antennenanschlüssen, die unterhalb des Randbereichs des Chipmoduls angeordnet sind, wobei bei eingebautem Chipmodul zwischen den Modulanschlüssen einerseits und den Körperkontaktanschlüssen anderseits Klebstoffteile aus leitfähigem Material unter Druckbeaufschlagung zur Herstellung eines Kontakts zwischen den Anschüssen angeordnet sind, wobei die Klebstoffteile aus elastischem Material innerhalb von Aussparungen des Kartenkörpers derart punktweise aufgetragen sind, dass sie im ausgehärteten Zustand vor der Druckbeaufschlagung die Aussparungen in Chipkartenlängs- und Chipkartenbreitenrichtung nicht ausfüllen und nach der Druckbeaufschlagung nahezu vollständig ausfüllen.

Vorzugsweise sind die Klebstoffteile innerhalb Aussparungen angeordnet, die in dem Kartenkörper unterhalb des Randbereichs des Chipmoduls angeordnet sind und bodenseitig mit den Körperkontaktanschlüssen abschließen. Derartige Aussparungen weisen eine ausreichende Volumengröße zur vollständigen Aufnahme der Klebstoffteile unter Druckbeaufschlagung auf.

Vorteilhaft wird bei der Herstellung von Chipkarten zunächst der Klebstoff tropfenförmig in die Aussparungen eingesetzt und seine Verfestigung abgewartet. Dies geschieht mittels einer speziellen hierfür entwickelten Maschine, die zunächst die Klebstofftropfen in der Größenordnung von µl dispensiert und anschließend über eine schnelle Abziehbewegung sich von dem Tropfen entfernt, um sogenannte Tropfnasen zu vermeiden. Auf diese Weise werden vorteilhaft halbkugelförmige Oberflächen des Klebstofftropfens erhalten, die für die elastische Wirkung eines derartigen Bumps entscheidend sind.

Um Aufschluss über die Qualität der Form der Halbkugeloberfläche zu erhalten, wird anschließend mittels einer Laserstrahlvorrichtung, die Reflektionsmessungen an der Halbkugeloberfläche und der sie umgebenden Flächenstruktur durchführt, eine Messung zu der Oberflächenstruktur durchgeführt.

Nach Auftragen eines derartigen tropfenförmigen Klebstoffteiles findet eine Stapelung der einzelnen Chipkarten für ca. 2 - 3 Stunden statt, um eine Aushärtung der Klebstoffteile zu erhalten. Anschließend werden in die aus dem Stapel einzeln entnommenen Chipkarten die Chipmodule implantiert. Hierbei wirken die ausgehärteten Klebstoffteile als flexible Bumps, die einen Kontakt zwischen den Anschlüssen selbst bei einem Verbiegen der Chipkarte sicherstellen.

Nach Einbau des Chipmoduls werden die Klebstoffteile durch die Modulanschlüsse des Chipmoduls nach unten gedrückt und erfahren hierdurch eine Ausdehnung in die Chipkartenlängs- und Chipkartenbreitenrichtungen. Sobald die Modulanschlüsse auf dem oberen

Randbereich der Aussparungen aufsetzten, ist nahezu die gesamte Volumengröße der Aussparungen mit den zusammengedrückten Klebstoffteilen ausgefüllt. Auf diese Weise wird eine weitere Ausdehnung der Klebstoffteile selbst nach langjähriger Benutzung der Chipkarte vermieden, wodurch die Bildung von Zwischenräumen zwischen den Modul- oder Körperkontaktanschlüssen und den Klebstoffteilen aus elastischem Material vermieden werden kann.

Weitere vorteilhafte Ausführungsformen ergeben sich aus den Unteransprüchen.

Vorteile und Zweckmäßigkeiten sind der nachfolgenden Beschreibung in Verbindung mit der Zeichnung zu entnehmen. Hierbei zeigen:
- Fig.1: eine Querschnittsansicht eines Ausschnitts einer Chipkarte gemäß dem Stand der Technik;
- Fig.2: eine Draufsicht einer Ausnehmung zur Aufnahme eines Chipmoduls einer Chipkar- te gemäß dem Stand der Technik;
- Fig.3: eine Querschnittsansicht eines Ausschnitts einer Chipkarte gemäß einer Ausfüh- rungsform der Erfindung vor dem Einbau des Chipmoduls und
- Fig.4: eine Querschnittsansicht des Ausschnitts der Chipkarte gemäß der in Fig. 3 gezeig- ten Ausführungsform der Erfindung nach dem Einbau des Chipmoduls.

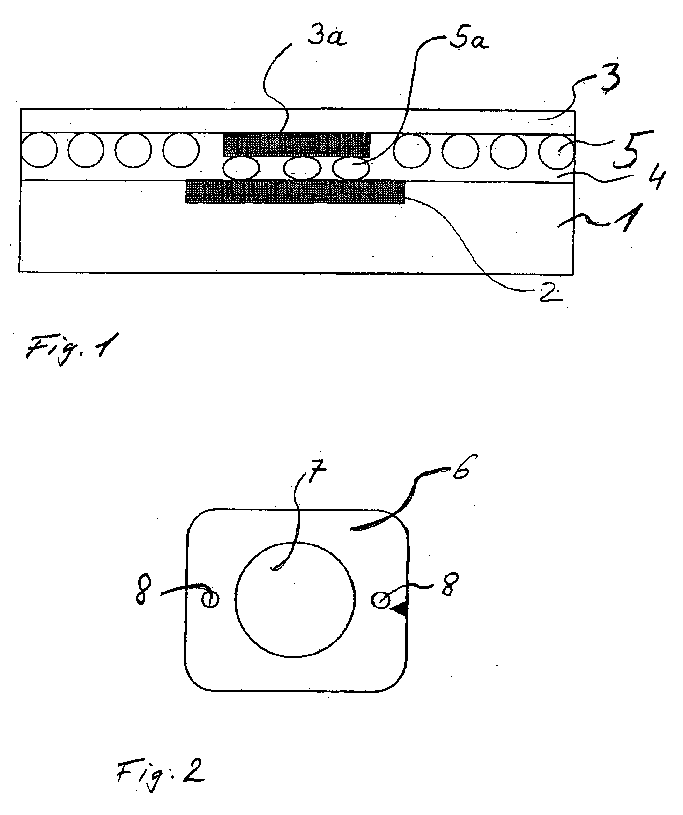

Figur 1 zeigt in einer Querschnittsansicht ausschnittsweise eine Chipkarte gemäß dem Stand der Technik, bei der nach demgenannten ACF-Verfahren ein Kartenkörper 1, in welchem ein leitfähiger Strukturkörper, wie eine Antenne mit Antennenanschlüssen 2 angeordnet ist, mit einem Chipmodul 3 mittels eines Heißklebers verbunden ist. Das Chipmodul 3 weist an seiner Unterseite Modulanschlüsse 3a auf, die nach dem Einbau des Chipmoduls mit den Antennenanschlüssen 2 elektrisch verbunden sein müssen.

Zur elektrischen Verbindung der Anschlüsse 2 und 3a sind in dem Heißkleber 4 leitfähige Partikel in Form von versilberten Glaskugeln 5 mit einem Durchmesser von ca. 50 µm angeordnet, die im Zwischenbereich zwischen den Anschlüssen 2 und 3a eine Kontaktierung der Anschlüsse bewirken, wie es durch das Bezugszeichen 5a dargestellt wird.

Derartige nach dem ACF-Verfahren hergestellte Chipkarten weisen nach der Durchführung von Biege- und Torsionstests einen deutlichen Qualitätsverlust in der elektrischen Verbindung zwischen den Anschlüssen 2 und 3a bereits bei einer Biegebeanspruchung von 750 bis 1000 Biegungen auf.

In Figur 2 wird in einer Draufsicht eine innerhalb eines hier nicht gezeigten Kartenkörpers angeordnete Ausnehmung (Kavität) für die Aufnahme eines Chipmoduls zeigt, wie sie aus dem Stand der Technik bekannt ist. Die Ausnehmung besteht aus einer Klebefläche 6 zum Verkleben des Chipmoduls mit dem Kartenkörper und einer etwas tiefer gesetzten Fläche 7, die genügend Freiraum für das an der Unterseite des Chipmoduls befindliche Die zur Verfügung stellt. Auf diese Weise wird das Chipmodul sozusagend "schwimmend" in dem Kartenkörper gelagert, mit dem es lediglich in seinem Randbereich fest verbunden ist.

Zusätzliche Bohrungen 8 sind von der Klebefläche 6 abwärts laufend zu den darunter liegenden Antennenanschlüssen angeordnet, um darin leitfähigen flüssigen Kleber anzuordnen. Nach dem Dosieren des Klebstoffes in den Bohrungen 8 wird unmittelbar darauf das Chipmodul auf die Klebefläche 6 gesetzt und durch Wärmeeinwirkung eine Aushärtung der verwendeten Klebstoffe bewirkt.

Aufgrund des in den Bohrungen 8 vorhandenen leitfähigen Klebstoffes findet eine elektrische Verbindung zwischen den hier nicht gezeigten Antennenanschlüssen und den hier nicht gezeigten darüber liegenden Modulanschlüssen des eingesetzten Chipmoduls statt.

Derartige Klebstoffverbindung weist infolge von Überdehnung und Ermüdungserscheinungen aufgrund auftretender dynamischer von außen auf die Chipkarte wirkenden Belastungen Rissbildungen auf.

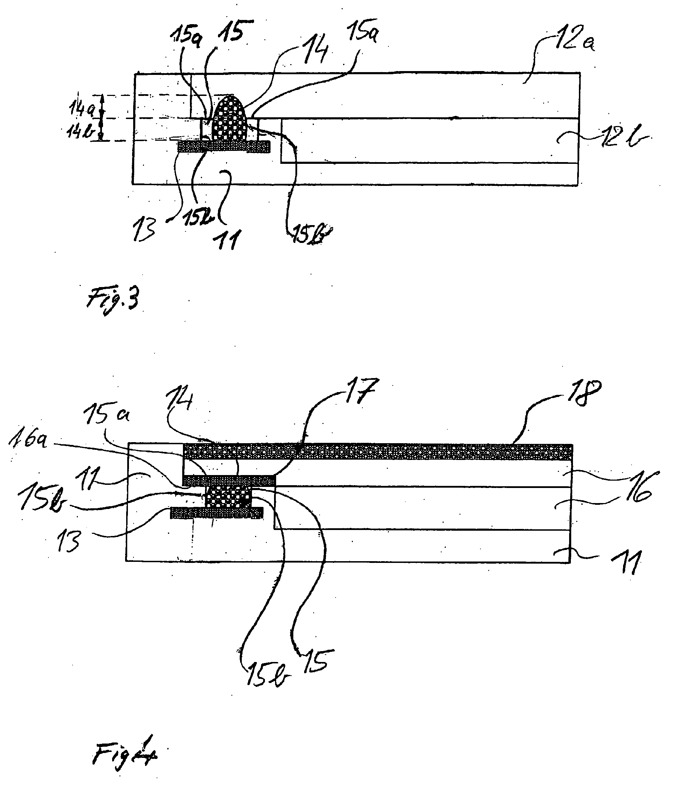

In Figur 3 wird in einer Querschnittsansicht ausschnittsweise eine Hälfte einer Chipkarte gemäß einer Ausführungsform der Erfindung gezeigt. In einem Kartenkörper 11 sind zwei unterschiedlich tiefe Ausnehmungen 12a und 12b zur Aufnahme eines Chipmoduls angeordnet. Innerhalb des Kartenkörpers 11 ist eine Antenne mit einem Antennenanschluss 13 einlaminiert, wobei der Antennenanschluss 13 unterhalb eines Randbereichs der Ausnehmung 12a angeordnet ist.

In einer oberhalb des Antennenanschlusses 13 schlitzartig oder bohrungsartig angeordneten Aussparung 15 innerhalb des Kartenkörpers 11 ist ein Klebstoffteil 14 aus elastischem, leitfähigem Material, das vorzugsweise auf Silikon oder silikonartigem Material basiert, mit einer Gesamthöhe 14a, 14b angeordnet. Der Höhenanteil 14b entspricht der Höhe der Aussparung 15, also dem Abstand von dem Antennenanschluss 13 zu einem oberen Randbereich 15a der Aussparung 15. Der Höhenanteil 14a entspricht dem Abstand von dem oberen Randbereich 15a bis zur Oberkante des Klebstoffteils 14 und beträgt vorzugsweise 0,05-0.15 mm.

In Figur 4 wird in einer Querschnittsansicht der Ausschnitt der in Figur 3 gezeigten Chipkarte nach dem Einbau der Chipkarte gezeigt. Gleiche oder gleichbedeutende Bauteile sind mit denselben Bezugzeichen bezeichnet.

Nachdem ein Chipmodul mit Modulanschlüssen 17 und oberseitigen Kontaktflächen 18 im Randbereich 16a des Chipmoduls 16 auf den Kartenkörper 11 gepresst damit verklebt worden ist, wird der Klebstoffteil 14 aus elastischem leitfähigem Material in Richtung des Chipkartendickenverlaufs zusammengedrückt und unter Druckbeaufschlagung an die beiden Anschlüsse 13 und 17 gepresst.

Die Volumengröße der Aussparung 15 mit ihren oberen Randbereich 15a und ihren seitlichen Randbereichen 15b ist derart bemessen, dass der Klebstoffteil 14 bei Aufliegen des Modulanschlusses 17 auf dem oberen Randbereich 15a der Aussparung 15 nahezu die gesamte Aussparung 15 ausfüllt, so dass ein Nachgeben des Klebstoffteils 14 in seitlicher Richtung - also in Chipkartenlängs- oder Chipkartenbreitenrichtung - selbst nach langjähriger Benutzung der Chipkarte nicht-möglich ist. Auf diese Weise wird ein dauerhafter elektrischer Kontakt des leitfähigen, elastischen Klebstoffteils zu den Modul- und Antennenanschlüssen 13 und 17 aufrechterhalten.

Die hier gezeigte erfindungsgemäße Chipkarte und das damit verbundene Herstellungsverfahren weisen gegenüber Chipkarten und Verfahren, bei denen Heißkleber verwendet werden, weiterhin den Vorteil auf, dass im Falle einer Auftragung von zuviel Klebstoffteilen kein seitliches Austreten und Verunreinigen der Kartenoberfläche beim Implantieren des Chipmoduls möglich ist, da die Klebstoffteile bereits vor dem Einbau des Chipmoduls ausgehärtet sind.

Sämtliche in den Anmeldungsunterlagen offenbarten Merkmale werden als erfindungswesentlich beansprucht, soweit sie einzeln oder in Kombination gegenüber dem Stand der Technik neu sind.

### Bezugszeichenliste

- 1: Kartenkörper
- 2: Kontaktanschluss einer Antenne
- 3: Chipmodul
- 4: Heißkleber
- 5, 5a: versilberte Glaskugeln
- 6: Klebefläche
- 7: untere Ausnehmungsfläche
- 8: Bohrungen
- 11: Kartenkörper
- 12a, 12b: Ausnehmungen
- 13: Antennenanschluss
- 14: Klebstoffteil
- 14a, 14b: Höhe des Klebstoffteils
- 15: Aussparung
- 15a: oberer Randbereich der Aussparung
- 15b: seitliche Ränder der Aussparung
- 16: Chipmodul
- 17: Modulanschluss
- 18: oberseitige Kontaktfläche des Chipmoduls

## Patentansprüche

1. Verfahren zur Herstellung von Chipkarten mit einem Kartenkörper (11), mindestens einer darin angeordneten Ausnehmung (12a, 12b) zur Aufnahme mindestens eines Chipmoduls (16) mit Modulanschlüssen (17) im Randbereich (16a) des Chipmoduls (16) und einem in den Kartenkörper (11) eingebetteten leitfähigen Strukturkörper mit Körperkontaktanschlüssen (13), insbesondere einer Antenne mit Antennenanschlüssen, die unterhalb des Randbereichs (16a) des Chipmoduls (16) angeordnet sind,
**dadurch gekennzeichnet, dass**
vor dem Einbau des Chipmoduls (11) Klebstoffteile (14) aus elastischem, leitfähigem Material auf die Körperkontaktanschlüsse (13) und/oder die Modulanschlüsse (17) innerhalb von Aussparungen (15) des Kartenkörpers (11) derart punktweise aufgetragen und ausgehärtet lassen werden, dass sie im ausgehärteten Zustand vor der Druckbeaufschlagung die Aussparungen (15) in Chipkartenlängs- und Chipkartenbreitenrichtung nicht ausfüllen und anschließend das Chipmodul (11) unter Druckbeaufschlagung der Klebstoffteile (14) aus elastischem Materials in den Kartenkörper (11) derart eingebaut wird, dass die Klebstoffteile (14) die nahezu gesamten Aussparungen (15) vollständig ausfüllen.

2. Verfahren nach Anspruch 1,
**dadurch gekennzeichnet, dass**
die Klebstoffteile (14) vordem Einbau des Chipmoduls (11) um 0,05 bis 0,15 mm höher als obere Randbereiche (15a) von im Kartenkörper angeordneten Aussparungen (15) zur Aufnahme der Klebstoffteile (14) aufgetragen werden.

3. Chipkarte, hergestellt nach dem Verfahren gemäß Anspruch 1 oder 2.

4. Chipkarte nach Anspruch 3 mit einem Kartenkörper (11), mindestens einer darin angeordneten Ausnehmung (12a, 12b) zur Aufnahme mindestens eines Chipmoduls (16) mit Modulanschlüssen (17) im Randbereich (16a) des Chipmoduls (16) und einem in den Kartenkörper (11) eingebetteten leitfähigen Strukturkörper mit Körperkontaktanschlüssen (13), insbesondere einer Antenne mit Antennenanschlüssen, die unterhalb des Randbereichs (16a) des Chipmoduls (16) angeordnet sind, wobei bei eingebautem Chipmodul (16) zwischen den Modulanschlüssen (17) einerseits und den Körperkontaktanschlüssen (13) anderseits Klebstoffteile (14) aus leitfähigem Material unter Druckbeaufschlagung zur Herstellung eines Kontakts zwischen den Anschlüssen (13, 17) angeordnet sind,
**dadurch gekennzeichnet, dass**
die Klebstoffteile (14) aus elastischem Material innerhalb von Aussparungen (15) des Kartenkörpers (11) derart punktweise aufgetragen sind, dass sie im ausgehärteten Zustand vor der Druckbeaufschlagung die Aussparungen (15) in Chipkarenlängs- und Chipkartenbreitenrichtung nicht ausfüllen und nach der Druckbeaufschlagung nahezu vollständig ausfüllen.

5. Chipkarte nach Anspruch 3 oder 4,
**dadurch gekennzeichnet, dass**
die Klebstoffteile (14) innerhalb Aussparungen (15) angeordnet sind, die in dem Kartenkörper (11) unterhalb des Randbereichs (16a) des Chipmoduls (16) angeordnet sind und bodenseitig mit den Körperkontaktanschlüssen (13) abschließen.

6. Chipkarte nach einem der Ansprüche 3 - 5,
**dadurch gekennzeichnet, dass**
die Aussparungen (15) eine ausreichende Volumengröße zur vollständigen Aufnahme der Klebstoffteile (14) unter Druckbeaufschlagung aufweisen.

7. Chipkarte nach einem der Ansprüche 3 - 6,
**dadurch gekennzeichnet, dass**
die Aussparungen (15) in Richtung des Kartenkörperdickenverlaufs Höhenabmessungen (14b) aufweisen, die geringer als die Höhe (14a, 14b) der punktweise aufgetragenen Klebstoffteile (14) ohne Druckbeaufschlagung sind.

8. Chipkarte nach einem der Ansprüche 3 - 7,
**dadurch gekennzeichnet, dass**
die Klebstoffteile (14) aus elastischem Material vor dem Einbau des Chipmoduls (11) ausgehärtet sind, die nach dem Einbau des Chipmoduls (11) als federwirkende Puffer einen dauerhaften Kontakt zwischen den Chipmodul- und Körperkontaktanschlüssen (13,17) herstellen.

9. Chipkarte nach einem der Ansprüche 3 - 8,
**dadurch gekennzeichnet, dass**
die Klebstoffteile (14) vorrangig entlang des Kartenkörperdickenverlaufs als federwirkende Puffer wirken.

## Claims

1. Method for producing chip cards comprising a card body (11), at least one recess (12a, 12b) arranged therein for receiving at least one chip module (16) having module connections (17) in the edge region (16a) of the chip module (16), and a conductive structural body embedded in the card body (11) and having body contact connections (13), in particular an antenna having antenna connections which are arranged below the edge region (16a) of the chip module (16), **characterised in that**, prior to installation of the chip module (11), adhesive parts (14) made from elastic, conductive material are applied as spots to the body contact connections (13) and/or the module connections (17) within cutouts (15) of the card body (11) and are left to cure in such a way that they do not fill the cutouts (15) in the chip card length direction and chip card width direction in the cured state prior to the application of pressure, and then the chip module (11) is installed in the card body (11) with pressure being applied to the adhesive parts (14) made from elastic material in such a way that the adhesive parts (14) completely fill almost the entire cutouts (15).

2. Method according to claim 1, **characterised in that** the adhesive parts (14) prior to installation of the chip module (11) are applied so as to be 0.05 to 0.15 mm higher than the upper edge regions (15a) of cutouts (15) arranged in the card body for receiving the adhesive parts (14).

3. Chip card, produced by the method according to claim 1 or 2.

4. Chip card according to claim 3, comprising a card body (11), at least one recess (12a, 12b) arranged therein for receiving at least one chip module (16) having module connections (17) in the edge region (16a) of the chip module (16), and a conductive structural body embedded in the card body (11) and having body contact connections (13), in particular an antenna having antenna connections which are arranged below the edge region (16a) of the chip module (16), wherein, with the chip module (16) installed between the module connections (17) on the one hand and the body contact connections (13) on the other hand, adhesive parts (14) made from conductive material are arranged between the connections (13, 17) with pressure being applied in order to produce a contact, **characterised in that** the adhesive parts (14) made from elastic material are applied as spots within cutouts (15) of the card body (11) in such a way that they do not fill the cutouts (15) in the chip card length direction and chip card width direction in the cured state prior to the application of pressure, and almost completely fill said cutouts after the application of pressure.

5. Chip card according to claim 3 or 4, **characterised in that** the adhesive parts (14) are arranged within cutouts (15) which are arranged in the card body (11) below the edge region (16a) of the chip module (16) and at the bottom terminate with the body contact connections (13).

6. Chip card according to one of claims 3 to 5, **characterised in that** the cutouts (15) have a sufficient size in volume terms so as to completely receive the adhesive parts (14) under the application of pressure.

7. Chip card according to one of claims 3 to 6, **characterised in that** the cutouts (15), in the direction of the card body thickness, have height dimensions (14b) which are smaller than the height (14, 14b) of the adhesive parts (14) applied as spots without the application of pressure.

8. Chip card according to one of claims 3 to 7, **characterised in that** the adhesive parts (14) made from elastic material are cured prior to installation of the chip module (11) and, after installation of the chip module (11), act as a spring-effect buffer to produce a permanent contact between the chip module connections (13) and body contact connections (17).

9. Chip card according to one of claims 3 to 8, **characterised in that** the adhesive parts (14) act as a spring-effect buffer primarily along the card body thickness direction.

## Revendications

1. Procédé de fabrication de cartes à puce avec un corps de carte (11), au moins un évidement (12a, 12b) disposé à l'intérieur pour recevoir au moins un module de puce (16) avec des connexions de module (17) dans la zone de bordure (16a) du module de puce (16), et un corps de structure conducteur enrobé dans le corps de carte (11) avec des connexions de contact de corps (13), en particulier une antenne avec des connexions d'antenne qui sont disposées au-dessous de la zone de bordure (16a) du module de puce (16), **caractérisé en ce qu'**avant de monter le module de puce (11), on applique ponctuellement et on laisse durcir des éléments adhésifs (14) en un matériau élastique et conducteur sur les connexions de contact de corps (13) et/ou les connexions de module (17), à l'intérieur de découpes (15) du corps de carte (11), 1 de manière qu'à l'état durci, avant la mise sous pression, ils ne remplissent pas les découpes (15) dans la direction de la longueur et la direction de la largeur de la carte à puce, et ensuite, sous l'action de la pression des éléments adhésifs (14) en matériau élastique, 1 le module de puce (11) est monté à l'intérieur du corps de carte (11) de façon que les éléments adhésifs (14) remplissent totalement la presque totalité des découpes (15).

2. Procédé selon la revendication 1, **caractérisé en ce que** les éléments adhésifs (14) sont appliqués, avant le montage du module de puce (11), de manière à dépasser de 0,05 à 0,15 mm en hauteur des zones de bordure supérieures (15a) de découpes (15), disposées dans le corps de carte, pour recevoir les éléments adhésifs (14).

3. Carte à puce, fabriquée selon le procédé de la revendication 1 ou 2.

4. Carte à puce selon la revendication 3 avec un corps de carte (11), au moins un évidement (12a, 12b) disposé à l'intérieur pour recevoir au moins un module de puce (16) avec des connexions de module (17) dans la zone de bordure (16a) du module de puce (16) et un corps de structure conducteur enrobé dans le corps de carte (11), avec des connexions de contact de corps (13), en particulier une antenne avec des connexions d'antenne qui sont disposées au-dessous de la zone de bordure (16a) du module de puce (16), dans laquelle, lorsque le module de puce (16) est monté, des éléments adhésifs (14) en un matériau conducteur sont disposés, entre les connexions de module (17) d'une part et les connexions de contact de corps (13) d'autre part, avec action d'une pression pour réaliser un contact entre les connexions (13, 17), **caractérisée en ce que** les éléments adhésifs (14) en matériau élastique sont appliqués ponctuellement, à l'intérieur de découpes (15) du corps de carte (11), de manière qu'à l'état durci, avant l'action de la pression, ils ne remplissent pas les découpes (15) dans la direction de la longueur et la direction de la largeur de la carte à puce, et les remplissent presque totalement après l'action de la pression.

5. Carte à puce selon l'une quelconque des revendications 3 ou 4, **caractérisée en ce que** les éléments adhésifs (14) sont disposés à l'intérieur de découpes (15) qui sont prévues dans le corps de carte (11) au-dessous de la zone de bordure (16a) du module de puce (16), et sont à fleur des connexions de contact de corps (13) côté fond.

6. Carte à puce selon l'une quelconque des revendications 3 à 5, **caractérisée en ce que** les découpes (15) présentent une dimension de volume suffisante pour recevoir complètement les éléments adhésifs (14) sous l'action de la pression.

7. Carte à puce selon l'une quelconque des revendications 3 à 6, **caractérisée en ce que** les découpes (15) présentent, dans la direction de l'épaisseur du corps de carte, des dimensions en hauteur qui sont inférieures à la hauteur (14a, 14b) des éléments adhésifs (14) appliqués ponctuellement, sans l'action de la pression.

8. Carte à puce selon l'une quelconque des revendications 3 à 7, **caractérisée en ce que** les éléments adhésifs (14) en matériau élastique sont durcis avant le montage du module de puce (11) et, après montage du module de puce (11), ils réalisent un tampon à effet de ressort qui assure un contact durable entre les connexions du module de puce et les connexions de contact de corps (13, 17).

9. Carte à puce selon l'une quelconque des revendications 3 à 8, **caractérisée en ce que** les éléments adhésifs (14) servent de tampon à effet de ressort principalement le long de l'épaisseur du corps de carte.
